# EUROPÄISCHE PATENTANMELDUNG

(11) **EP 3 629 438 A1**
(43) Veröffentlichungstag der Anmeldung: **01.04.2020**
(21) Anmeldenummer: 18196785.2
(22) Anmeldetag: 26.09.2018
(51) Int. Cl.: H02J 3/00, H02J 13/00, G05B 23/02, H04B 3/54, G01R 31/08

(54) **VERFAHREN UND EINE VORRICHTUNG ZUR BESTIMMUNG DES NETZZUSTANDES EINES NIEDERSPANNUNGSNETZES EINES ENERGIEVERSORGUNGSSYSTEMS**

(71) Anmelder: Siemens Aktiengesellschaft, 80333 München (DE)
(72) Erfinder: Hanak, Peter, 1090 Wien (AT); Siljak, Nedzad, 1210 Wien (AT); Wöhrer, Andreas, 1220 Wien (AT)
(74) Vertreter: Maier, Daniel Oliver

(57) **Zusammenfassung**

Verfahren zur Bestimmung des Netzzustandes eines Niederspannungsnetzes (1), welches eine erste Netzleitung (311) mit einem ersten Smartmeter (101) und eine zweite Netzleitung (312-319) mit einem zweiten Smartmeter (102-109) aufweist, und die erste und zweite Netzleitung (311-319) eine Netztopologie (310) des Niederspannungsnetzes (1) bilden,
und das Energieversorgungssystem (2) mit dem ersten und zweiten Smartmeter (101-109) über jeweils einen Kommunikationspfad mittels eines Fernabfrage-Vorgangs (10) kommuniziert, wobei die Kommunikationspfade ein Kommunikationsnetz mit einer Kommunikationstopologie (320) bilden, und folgende Verfahrensschritte ausgeführt werden:
a) Senden eines Abfrage-Telegramms (11) an das erste und das zweite Smartmeter (101-109),
b) Ermitteln von Eigenschaften der Kommunikation als Kommunikationsparameter (6) aus dem Abfrage-Telegramm (11),
c) Übertragen eines Antwort-Telegramms (12) mit dem Kommunikationsparameter (6),
d) Erfassen der Kommunikationstopologie (320) des ersten und des zweiten Smartmeters (101-109) aus dem Antwort-Telegramm (12),
e) Bestimmen des Netzzustands des Niederspannungsnetzes (1) aus dem Kommunikationsparameter (6), der Netztopologie (310) und der Kommunikationstopologie (320).

## Beschreibung

Die Erfindung betrifft ein Verfahren und eine Vorrichtung zur Bestimmung des Netzzustandes eines Niederspannungsnetzes eines Energieversorgungssystems, welches Energieversorgungssystem eine erste Netzleitung mit einem ersten Smartmeter und zumindest eine zweite Netzleitung mit zumindest einem zweiten Smartmeter aufweist, und die erste Netzleitung und die zumindest eine zweite Netzleitung eine Netztopologie des Niederspannungsnetzes bilden, und das erste Smartmeter sowie das zumindest eine zweite Smartmeter über jeweils einen Kommunikationspfad mit zumindest einem Gateway eines Kommunikationssystems des Energieversorgungssystems verbunden sind und mittels zumindest eines Fernabfrage-Vorgangs, umfassend jeweils ein Abfrage-Telegramm und ein Antwort-Telegramm, kommunizieren, wobei die Kommunikationspfade ein Kommunikationsnetz mit einer Kommunikationstopologie bilden.

Niederspannungsnetze sind heutzutage teilweise alt und störungsanfällig, was zu unerwünschten Ausfällen in der Versorgung der Verbraucher, als auch zu kostenintensiven Wartungs- und Reparaturarbeiten der Netzleitungen führen kann.

Es ist oft schwierig, im Zuge von Wartungsarbeiten zukünftige Störungen oder Ausfälle des Netzes zu erkennen, um beispielsweise präventiv einen Austausch einer Komponente, die auszufallen droht, durchzuführen. Mit anderen Worten kann ein Ausfall nur sehr schwer prognostiziert werden. Ein unbegründeter, präventiv vorgenommener Austausch von Komponenten ist in den meisten Fällen wirtschaftlich nicht sinnvoll.

Ferner ist es häufig nötig, dass ein Verbraucher eine Störung beziehungsweise einen Ausfall des Netzes beispielsweise telefonisch meldet, bevor eine entsprechende Reparatur begonnen werden kann. Dadurch kann sich die Ausfallzeit unerwünscht weiter vergrößern.

Außerdem kann es für einen Netzbetreiber eines Niederspanungsnetzes schwierig sein festzustellen, über welche aktiven Netzversorgungsleitungen tatsächlich die Netzversorgung erfolgt, da dies von der manuellen Konfiguration von Leitungsschaltern, welche zwischen mehreren Netzleitungen umgeschaltet werden können, abhängen kann, deren Schaltbelegung zumeist nicht fernabfragbar ist. Die Kenntnis der aktuell aktiven Netzleitungen ist beispielsweise für Wartungs- oder Reparaturarbeiten wichtig.

Es ist eine Aufgabe der Erfindung, die genannten Nachteile zu überwinden.

Die Aufgabe wird durch ein Verfahren der eingangs genannten Art gelöst, indem folgende Verfahrensschritte ausgeführt werden:
a) Senden des Abfrage-Telegramms des Fernabfrage-Vorgangs an das erste Smartmeter und das zumindest eine zweite Smartmeter,
b) Ermitteln von Eigenschaften der Kommunikation zwischen dem zumindest einen Gateway und dem ersten Smartmeter und/oder dem zumindest einen zweiten Smartmeter als zumindest ein Kommunikationsparameter aus zumindest einem Abfrage-Telegramm durch das jeweilige Smartmeter,
c) Übertragen eines Antwort-Telegramms des Fernabfrage-Vorgangs an eine Überwachungsvorrichtung des Energieversorgungssystems, welches den zumindest einen Kommunikationsparameter umfasst,
d) Erfassen der Kommunikationstopologie des ersten Smartmeters und des zumindest einen zweiten Smartmeters aus dem zumindest einem Antwort-Telegramm durch die Überwachungsvorrichtung,
e) Bestimmen des Netzzustands des Niederspannungsnetzes aus dem zumindest einen Kommunikationsparameter, der Netztopologie und der Kommunikationstopologie durch die Überwachungsvorrichtung.

In Niederspannungsnetzen werden heutzutage häufig intelligente Stromzähler, sogenannte Smartmeter, eingesetzt. Solche Niederspannungsnetze werden als intelligente Niederspannungsnetze beziehungsweise Smart-Grids bezeichnet, bei welchen beispielsweise ein einfaches und kostengünstiges Fernablesen des Zählerstandes eines intelligenten Stromzählers möglich ist.

Das erfindungsgemäße Verfahren kann statt oder zusätzlich zu einem Smartmeter auch mit anderen Messvorrichtungen mit einer entsprechenden Kommunikationsschnittstelle durchgeführt werden, beispielsweise mit einem Messgerät zur Bestimmung von Leitungsparametern. Folglich umfasst der Begriff Smartmeter auch andere geeignete Messvorrichtungen und das Energieversorgungsystem kann auch Kombinationen von Smartmetern und anderen Messvorrichtungen umfassen.

Erfindungsgemäß sollen zusätzlich Informationen der einzelnen Smartmeter bzw. die Analyse der Datenübertragungsqualität beziehungsweise die Topologie des Datenübertragungsnetzwerks von Fernabfrage-Vorgängen zur Abschätzung des Netzzustandes des Niederspannungsnetzes herangezogen werden. Ferner kann auf den aktuellen Netzzustand rückgeschlossen werden, beispielsweise auf Schalterstellungen im Niederspannungsnetz, wobei diese Information auch an ein SCADA-System (Supervisory Control and Data Acquisition) weitergeleitet werden kann. Unversorgte Netze könnten durch entsprechende Algorithmen innerhalb der Überwachungsvorrichtung automatisch erkannt werden.

Der Einsatz von Technologien neuronaler Netze ist denkbar, wobei beispielsweise anhand eines einzelnen ermittelten kritischen Versorgungszustands einer einzelnen Netzleitung die Auswahl weiterer Netzleitungen, welche in weiterer Folge analysiert werden sollen, automatisch initiiert werden kann. Veränderungen in der Kommunikationsqualität von intelligenten Stromzählern lassen unter Berücksichtigung der Anschluss- und Kommunikationstopologie und Verknüpfung mit zusätzlichen Daten (wie beispielsweise Witterungsinformationen) Rückschlüsse auf den Versorgungszustand im Netz zu. Dadurch ist es möglich, Störungsfälle durch eine entsprechende Prognostizierung zu vermeiden.

Durch das erfindungsgemäße Verfahren ist es möglich, dass der Versorgungszustand einzelner, mehrerer oder auch aller Netzleitungen im Niederspannungsnetz gezielt bestimmt werden kann und gegebenenfalls entsprechende Maßnahmen ergriffen werden können. Durch die Nutzung der elektronischen Fernabfrage von Smartmetern ist das erfindungsgemäße Verfahren auch in bestehende Smart-Grids äußerst einfach zu integrieren.

Durch das erfindungsgemäße Verfahren kann erreicht werden, dass beispielsweise der Netzzustand mittels Fernabfragen von einer zentralen Überwachungsvorrichtung auf einer einfache Weise ermittelt werden kann und entsprechende Wartung-, Instandhaltungs-, Reparaturarbeiten vor der Entstehung eines potentiellen teilweisen oder totalen Netzausfalls geplant und durchgeführt werden können. Materialermüdung oder Verschleiß von Transformatoren, Schaltern oder Leitungen oder Teilen daraus können mit einer gewissen Wahrscheinlichkeit vorab erkannt werden.

Im Schritt e) kann die Bestimmung des Netzzustands beispielsweise dadurch erfolgen, dass eine Änderung der Struktur einer Kommunikationstopologie gegenüber der Struktur einer Netztopologie analysiert wird.

Zusätzlich können zeitlich sich ändernde Kommunikationsparameter, beispielsweise in der Qualität der Kommunikation, einen Hinweis auf ein Gebrechen oder Alterung in einer Leitung, einem Schalter oder ähnlichem geben. Der zeitliche Verlauf der Änderung kann sowohl über eine kurze Periode, als auch über eine lange Zeitspanne beobachtet und analysiert werden. Beispielsweise können Witterungseinflüsse, jahreszeitliche oder arbeitszeitliche Einflüsse, oder auch betriebliche Einflüsse mit einer Änderung der Struktur einer Kommunikations-topologie abgeglichen werden, indem eine temporär geänderte Kommunikationstopologie mit geografisch geordneten Wetterdaten in Verbindung gebracht werden, insbesondere wenn mehr als eine Netzleitung oder mehr als ein Kommunikationspfad mit entsprechenden Wetterdaten korreliert.

Außerdem ist es möglich, dass Änderungen in der Netztopologie erfasst werden, wenn beispielsweise Reparaturarbeiten im Niederspannungsnetz durchgeführt werden und eine Netzleitung deshalb abgeschaltet wird. Eine Abschaltung einer Netzleitung kann auch zur gezielten Fehlersuche durchgeführt werden. In diesen Fällen kann auf die geänderte Netztopologie eine Änderung der Kommunikationstopologie festgestellt werden und untersucht werden.

Es können beispielsweise auch Kombinationen aus mehreren Kommunikationsparametern verschiedener Netzleitungen einen Hinweis auf eine Störung geben, insbesondere ein zeitlicher Verlauf von Änderungen der Kommunikationsparameter.

In analoger Weise zum erfindungsgemäßen Verfahren wird die Aufgabe der Erfindung auch durch eine Vorrichtung der eingangs genannten Art gelöst, indem das Energieversorgungssystem ferner eine Überwachungsvorrichtung umfasst, welche mit dem zumindest einen Gateway verbunden ist, und das Energieversorgungssystem dazu eingerichtet ist, folgende Verfahrensschritte auszuführen:
a) Senden eines Abfrage-Telegramms eines Fernabfrage-Vorgangs an das erste Smartmeter und das zumindest eine zweite Smartmeter,
b) Ermitteln von Eigenschaften der Kommunikation zwischen dem zumindest einen Gateway und dem ersten Smartmeter und/oder dem zumindest einen zweiten Smartmeter als zumindest ein Kommunikationsparameteraus zumindest einem Abfrage-Telegramm durch das jeweilige Smartmeter,
c) Übertragen eines Antwort-Telegramms des Fernabfrage-Vorgangs an die Überwachungsvorrichtung, welches den zumindest einen Kommunikationsparameter umfasst,
d) Erfassen der Kommunikationstopologie des ersten Smartmeters und des zumindest einen zweiten Smartmeters aus dem zumindest einem Abfrage-Telegramm durch die Überwachungsvorrichtung,
e) Bestimmen des Netzzustands des Niederspannungsnetzes aus dem zumindest einen Kommunikationsparameter, der Netztopologie und der Kommunikationstopologie durch die Überwachungsvorrichtung.

Vorteilhafte Ausgestaltungen und Weiterbildungen der Erfindung sind in den abhängigen Patentansprüchen angegeben. Die Vorteile entstehen sowohl für das erfindungsgemäßen Verfahren als auch für die erfindungsgemäßen Vorrichtung.

Die erfindungsgemäße Vorrichtung kann statt oder zusätzlich zu den Smartmetern auch andere Messvorrichtungen mit einer entsprechenden Kommunikationsschnittstelle umfassen, beispielsweise ein oder mehrere Messgeräte zur Bestimmung von Leitungsparametern. Folglich deckt der Begriff Smartmeter auch andere geeignete Messvorrichtungen ab.

Es ist vorteilhaft, wenn der zumindest eine Kommunikationsparameter aus einem Link-Quality-Index-Parameter des jeweiligen Smartmeters bestimmt wird. Dadurch lässt sich der zumindest eine Kommunikationsparameter auf besonders einfache Weise bestimmen.

Fernern ist es vorteilhaft, wenn der Link-Quality-Index-Parameter aus dem Signal-Rausch-Abstand zumindest aus Teilen zumindest eines Fernabfrage-Vorgangs bestimmt wird. Dadurch lässt sich der Link-Quality-Index-Parameter auf besonders einfache Weise bestimmen.

Es ist günstig, wenn der zumindest eine Kommunikationsparameter und/oder die Kommunikationstopologie aus einer Routing-Information, welche den Kommunikationspfad zwischen dem zumindest einen Gateway und dem jeweiligen
Smartmeter beschreibt, bestimmt wird. Dadurch lässt sich der zumindest eine Kommunikationsparameter auf besonders einfache Weise bestimmen.

Es ist dabei günstig, wenn die Routing-Information von dem jeweiligen Smartmeter bestimmt wird. Dadurch lässt sich die Routing-Information auf besonders einfache Weise bestimmen.

Fernern ist es vorteilhaft, wenn der zumindest eine Kommunikationsparameteraus der Dauer der Zeitdifferenz zwischen Absenden des zumindest einen Abfrage-Telegramms und Empfangen des zugehörigen Antwort-Telegramms des eines jeweiligen Fernabfrage-Vorgangs bestimmt wird. Dadurch lässt sich der zumindest eine Kommunikationsparameter auf besonders einfache Weise bestimmen.

In einer Weiterbildung der Erfindung werden die Schritte a) bis e) als ein erster Fernabfrage-Vorgang und zumindest ein zweiter Fernabfrage-Vorgang wiederholt ausgeführt, wobei aus dem ersten Fernabfrage-Vorgang und dem zumindest einen zweiten Fernabfrage-Vorgang eine Änderung der Kommunikationstopologie und/oder der Netztopologie feststellbar ist, aus welcher der Netzzustand bestimmt werden kann. Dadurch lässt sich eine Änderung des Netzzustandes auf besonders einfache Weise feststellen.

In einer anderen Weiterbildung der Erfindung ist die Netztopologie von der Überwachungsvorrichtung erfasst. Dadurch kann auf einfache Weise eine Konfiguration der Niederspannungsnetzes für die Verwendung im erfindungsgemäßen Verfahren speichern. Dabei ist es günstig, wenn die Netztopologie in Form einer Liste in einem Datenspeicher der Überwachungsvorrichtung gespeichert und änderbar ist.

Es ist vorteilhaft, wenn das Abfrage-Telegramm eine Zählerstands-Abfrage oder eine Betriebszustands-Abfrage des jeweiligen Smartmeters umfasst. Dadurch lässt sich der zumindest eine Kommunikationsparameter auf besonders einfache Weise bestimmen.

Weitere vorteilhafte Eigenschaften der Erfindung ergeben sich aus deren beispielhafter Erläuterung anhand der Figuren. Die Figuren zeigen in
- Fig. 1a: ein Blockschaltbild eines ersten Ausführungsbeispiels eines Niederspannungsnetzes,
- Fig. 1b: eine schematische Darstellung einer Netztopologie des Niederspannungsnetzes gemäß Fig. 1a,
- Fig. 1c: eine schematische Darstellung einer Kommunikationstopologie des Niederspannungsnetzes gemäß Fig. 1a,
- Fig. 2a: ein Blockschaltbild eines zweiten Ausführungsbeispiels eines Niederspannungsnetzes,
- Fig. 2b: eine schematische Darstellung einer Netztopologie des Niederspannungsnetzes gemäß Fig. 2a,
- Fig. 2c: eine schematische Darstellung einer Kommunikationstopologie des Niederspannungsnetzes gemäß Fig. 2a,
- Fig. 3a: ein Blockschaltbild eines dritten Ausführungsbeispiels eines Niederspannungsnetzes,
- Fig. 3b: eine schematische Darstellung einer Netztopologie des Niederspannungsnetzes gemäß Fig. 3a,
- Fig. 3c: eine schematische Darstellung einer Kommunikationstopologie des Niederspannungsnetzes gemäß Fig. 3a,
- Fig. 4: eine schematische Darstellung mit einem Ausführungsbeispiel für ein erfindungsgemäßes Verfahren,
- Fig. 5a: eine schematische Darstellung für einen Fernabfrage-Vorgang mit Telegrammen nach den Fig. 1a-1c, Fig. 2a-2c und Fig. 3a-3c,
- Fig. 5b: eine schematische Darstellung für ein weiteres Ausführungsbeispiel für einen Fernabfrage-Vorgang mit Telegrammen,
- Fig. 5c: eine schematische Darstellung für ein weiteres Ausführungsbeispiel für einen Fernabfrage-Vorgang mit Telegrammen,
- Fig. 5d: eine schematische Darstellung für ein weiteres Ausführungsbeispiel für einen Fernabfrage-Vorgang mit Telegrammen.

Die Ausführungsbeispiele zeigen wichtige Teile der Erfindung, wobei klar ist, dass für das erfindungsgemäße Verfahren und die Vorrichtung weitere Komponenten notwendig sein können, wie beispielsweise elektrische Endverbraucher, allgemein bekannte Infrastruktur zum Betrieb eines Niederspannungsnetzes, wie Transformatoren oder Leitungschalter, aber auch Steuerungs- und Datenverarbeitungsvorrichtungen. Zur besseren Übersicht sind diese Komponenten nicht dargestellt.

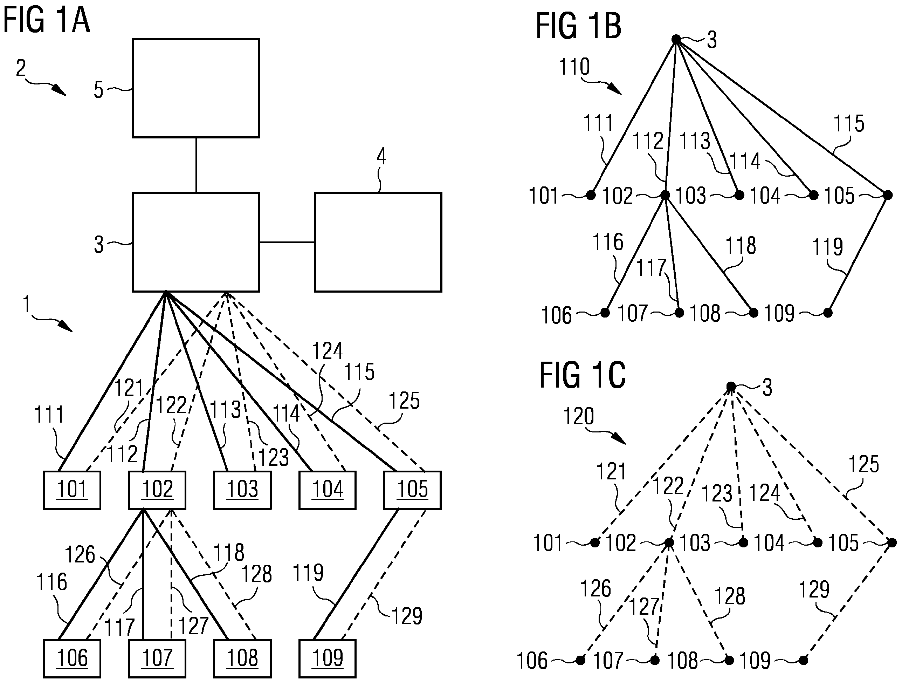

In Fig. 1a ist schematisch ein erstes Ausführungsbeispiel für eine Vorrichtung zur Bestimmung des Netzzustandes eines Niederspannungsnetzes 1 eines Energieversorgungssystems 2 gezeigt.

Das Energieversorgungssystem 2 weist eine erste Netzleitung 111 mit einem ersten Smartmeter 101 und mehrere zweite Netzleitungen 112-119 mit zugehörigen zweiten Smartmetern 102-109 auf. Mit den Smartmetern 101-109 können jeweils elektrische Verbraucher verbunden sein.

Mit den jeweiligen Smartmetern 101-109 kann beispielsweise der Stromverbrauch des Verbrauchers per Fernauslesung von einer entfernt gelegenen Datenverarbeitungseinrichtung gemessen werden, oder der Verbraucher per Fernsteuerung von einer entfernt gelegenen Steuerungsvorrichtung mit dem Niederspannungsnetz 1 verbunden beziehungsweise vom Netz getrennt werden.

Statt oder zusätzlich zu den jeweiligen Smartmetern 101-109 können auch andere Messvorrichtungen mit einer entsprechenden Kommunikationsschnittstelle eingesetzt werden, beispielsweise Messgeräte zur Bestimmung von speziellen Leitungsparametern. Diese Messvorrichtungen können beispielsweise temporär zur Unterstützung bei einer Fehlersuche in das Niederspannungsnetz 1 integriert werden. Auf diesen Aspekt wird in diesem Ausführungsbeispiel jedoch nicht näher eingegangen.

Die erste Netzleitung 111 und die zweiten Netzleitungen 112-119 bilden eine Netztopologie 110 des Niederspannungsnetzes 1, welche in Fig. 1b gesondert dargestellt ist.

Das Energieversorgungssystem 2 weist ferner ein Kommunikationssystem mit einem Gateway 3, sowie einen Smart-Grid-Server 5 auf. Der Smart-Grid-Server 5 unterstützt den elektronischen Betrieb des Energieversorgungssystems 2, das heißt beispielsweise durch elektronisches Fern-Auslesen der Zählerwerte der einzelnen Smartmeter 101-109 oder durch die allgemeine Steuerung der Smartmeter, wie Ein- und Ausschalten einzelner Netzleitungen 111-119.

Alternativ, hier nicht gezeigt, kann die Überwachungsvorrichtung 4 mit dem Smart-Grid Server 5 verbunden sein, wobei eine Kommunikation über das Gateway 3 mittels dem Smart-Grid Server 5 erfolgen kann. Dadurch kann eine Vereinfachung des Systems erreicht werden.

Das Gateway 3 kann beispielsweise ein IP-Router basierend auf der Powerline-Communication (PLC) Technologie sein, wobei die Kommunikation über das elektrische Versorgungsnetz des Niederspannungsnetzes 1 erfolgt.

Die Smartmeter 101-109 sind in diesem Ausführungsbeispiel mit dem Gateway 3 jeweils durch die Netzleitungen 111-119 stern- bzw. baumförmig verbunden.

In diesem Beispiel sind in der Baum-Hierarchie des Niederspannungsnetzes 1 Neben-Netzleitungen 116-118 der Slave-Smartmeter 106-108 mit dem Master-Smartmeter 102 bzw. die Neben-Netzleitung 119 des Slave-Smartmeters 109 mit dem Master-Smartmeter 105 verbunden.

Mit Master-Smartmetern 101-105 sind Smartmeter in der ersten Hierarchieebene eines Baumes, also in einer sternförmigen Anordnung gemeint. Mit anderen Worten jene, die direkt mit dem Gateway 3 kommunizieren können.

Mit Slave-Smartmetern 106-109 sind Smartmeter in der zweiten Hierarchieebene des Baumes gemeint, in der Praxis können aber weitaus mehr Hierarchieebenen in Bäumen angewandt werden. Mit anderen Worten jene, die nicht direkt mit dem Gateway 3 kommunizieren können, sondern nur über ein Master-Smartmeter 102, 105.

Eine Kommunikation zwischen dem Gateway 3 und dem Slave-Smartmeter 109 erfolgt somit durch ein Routing über das Master-Smartmeter 105, das heißt über die Netzleitungen 115 und 119.

Das Kommunikationssystem ist dazu eingerichtet, das erste Smartmeter 101 sowie die zweiten Smartmeter 102-109 über jeweils einen Kommunikationspfad mit dem Gateway 3 zu verbinden und mittels zumindest eines Fernabfrage-Vorgangs 10, 20, 30, 40, 50, 60 zu kommunizieren. Das Kommunikationssystem basiert dabei auf einer Powerline-Communication (PLC) Technologie. Das Gateway 3 kann über eine drahtgebundene oder drahtlose Breitband-Datenleitung mit dem Smart-Grid-Server 5 verbunden sein.

Die Kommunikationspfade bilden dabei ein Kommunikationsnetz mit einer Kommunikationstopologie 120, welche in Fig. 1c gesondert dargestellt ist. In diesem Ausführungsbeispiel entspricht die Netztopologie 110 der Kommunikationstopologie 120.

Die Fernabfrage-Vorgänge 10, 20, 30, 40, 50, 60 umfassend jeweils ein Abfrage-Telegramm 11, 21, 31, 41, 51, 61 und ein Antwort-Telegramm 12, 22, 32, 42, 52.

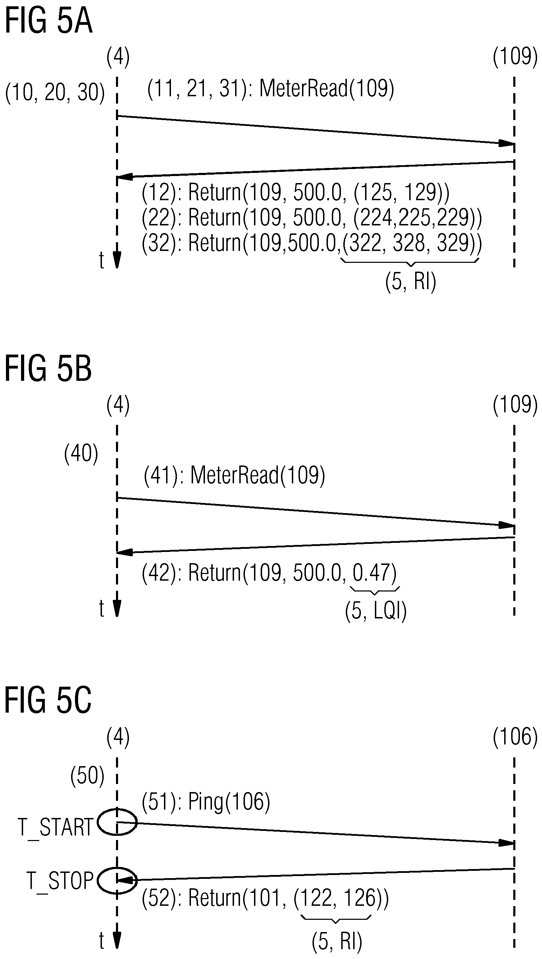

Das Abfrage-Telegramm 11, 21, 31, 41, 51, 61 weist ferner eine Zählerstands-Abfrage oder eine Betriebszustands-Abfrage des jeweiligen Smartmeters 101-109 auf. Beispiele für Fernabfrage-Vorgänge 10, 20, 30, 40, 50, 60 sind in der Fig. 5a-5d dargestellt.

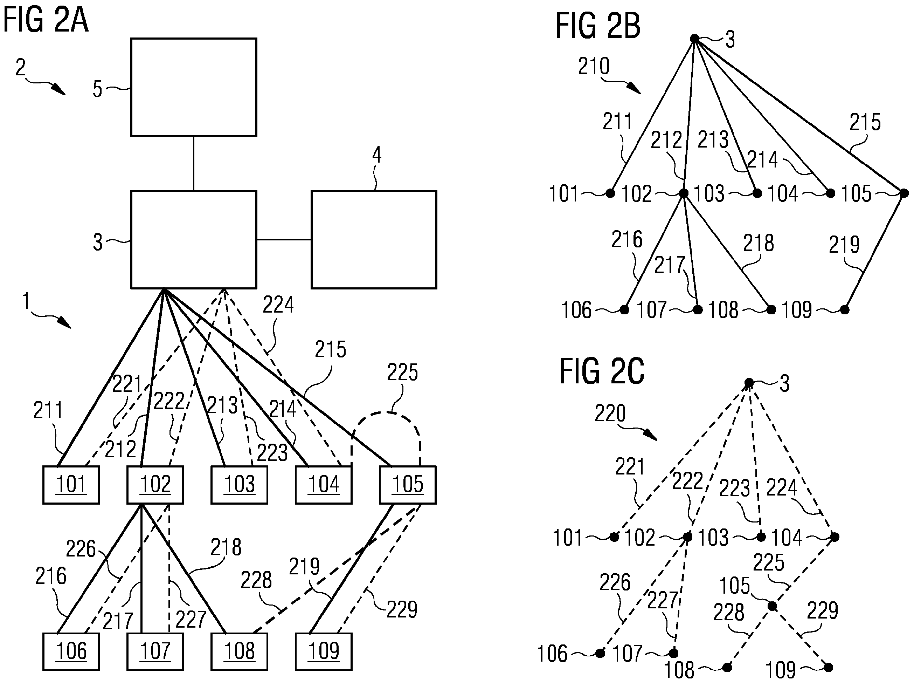

In Fig. 2a ist schematisch ein zweites Ausführungsbeispiel für eine Vorrichtung zur Bestimmung des Netzzustandes eines Niederspannungsnetzes 1 eines Energieversorgungssystems 2 gezeigt. Dabei ist eine Netztopologie 210 mit Netzleitungen 211-219 identisch zur Netztopologie 110 der Fig. 1a,wie in Fig. 2b erkennbar.

Jedoch unterscheidet sich eine Kommunikationstopologie 220 von der Kommunikationstopologie 120.

Der Kommunikationspfad 125 zum Smartmeter 105 des ersten Ausführungsbeispiels ist im zweiten Ausführungsbeispiel gestört. Stattdessen kommuniziert das Smartmeter 105 über den Kommunikationspfad 224 und 225.

Die Störung kann beispielsweise durch Alterung von Komponenten des Niederspannungsnetzes, Witterungseinflüsse oder jahreszeitliche Einflüsse hervorgerufen sein. Ferner sind Störungen durch betriebliche oder lastabhängige Einflüsse möglich, welche beispielsweise während Arbeitszeiten auftreten und nicht an Wochenenden.

Zu betrieblichen Einflüssen zählen unter anderem Wartungs- und Instandhaltungsarbeiten, der Austausch von Teilen des Niederspannungsnetzes, das Umschalten von Netzleitungen, beispielsweise von alternativen Transformatoren oder Leitungen.

Zu lastabhängigen Einflüssen zählen unter anderem das Einschalten von Verbrauchern mit hohen Störspannungen bei spezifischen Frequenzen, welche in das Niederspannungsnetz eingekoppelt werden können und die Qualität des Kommunikationsnetzes ungünstig beeinflussen können, sowie das Hinzunehmen und Trennen von Großverbrauchern.

Die Qualität des Kommunikationsnetzes kann beispielsweise durch eine Änderung der Signal-Laufzeiten (roundtrip), der Anzahl der Baum-Ebenen in einer Kommunikations-Topologie (Anzahl der Hops einer Verbindung) oder einem schlechten Signalzu-Rausch-Abstand beeinflusst werden.

Außerdem konnte der Kommunikationspfad 128 zum Smartmeter 105 des ersten Ausführungsbeispiels nicht aufgebaut werden, sondern das Smartmeter 108 kommuniziert im zweiten Ausführungsbeispiel über den Kommunikationspfad 224, 225 und 228.

Die Netztopologie 210 des zweiten Ausführungsbeispiels mit die Netzleitungen 211-219 entspricht strukturell der Netztopologie 110 des ersten Ausführungsbeispiels.

Die baumartige Kommunikationstopologie 220 des zweiten Ausführungsbeispiels ist in Fig. 2c dargestellt. Es ist in der Kommunikationstopologie 220 gegenüber der Kommunikationstopologie 120 eine zusätzliche Ebene erkennbar, welche durch den Kommunikationspfad 225 verursacht ist.

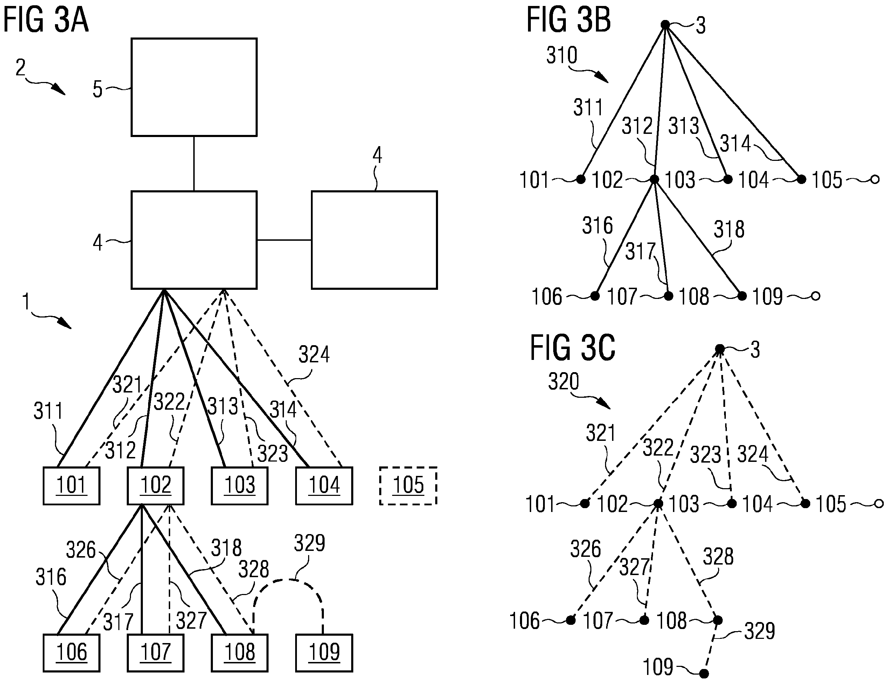

In Fig. 3a ist schematisch ein drittes Ausführungsbeispiel für eine Vorrichtung zur Bestimmung des Netzzustandes eines Niederspannungsnetzes 1 eines Energieversorgungssystems 2 gezeigt.

Wie in Fig. 3b erkennbar, unterscheidet sich eine Netztopologie 310 mit Netzleitungen 311-319 zur Netztopologie 110 der Fig. 1a dahingehend, dass die Netzleitung 125 zum Smartmeter 105 des ersten Ausführungsbeispiels der Fig. 1a unterbrochen ist. In weiterer Folge ist auch die Netzleitung 119 zum Smartmeter 109 unterbrochen.

Somit weist das dritte Ausführungsbeispiel in Fig. 3a nur Netzleitungen 311-314 und 316-318 auf.

Jedoch unterscheidet sich eine Kommunikationstopologie 320 von den Kommunikationstopologien 120 und 220 deutlich.

Das Smartmeter 109 ist trotz gestörter Netzleitung über einen Kommunikationspfad 319 mit dem Smartmeter 108 verbunden. Somit kann das Smartmeter 109 über die Kommunikationspfade 322, 328 und 329 mit dem Gateway 4 kommunizieren.

Die Netztopologie 310 des dritten Ausführungsbeispiels unterscheidet sich somit strukturell von den Netztopologien 110 und 210.

Die baumartige Kommunikationstopologie 320 des dritten Ausführungsbeispiels ist in Fig. 3c dargestellt. Es ist in der Kommunikationstopologie 220 gegenüber der Kommunikationstopologie 120 eine zusätzliche Ebene erkennbar, welche durch den Kommunikationspfad 329 verursacht ist.

Das Energieversorgungssystem 2 weist ferner eine Überwachungsvorrichtung 4 auf, welche mit dem zumindest einen Gateway 3 verbunden ist.

Das Energieversorgungssystem 2 ist dazu eingerichtet, folgende Verfahrensschritte eines Verfahrens 500 auszuführen:
a) Senden 510 eines Abfrage-Telegramms 11, 21, 31, 41, 51, 61 eines Fernabfrage-Vorgangs 10, 20, 30, 40, 50, 60 an das erste Smartmeter 101 und das zumindest eine zweite Smartmeter 102-109,
b) Ermitteln 520 von Eigenschaften der Kommunikation zwischen dem zumindest einen Gateway 3 und dem ersten Smartmeter 101 und/oder dem zumindest einen zweiten Smartmeter 102-109 als zumindest ein Kommunikationsparameter 6 aus zumindest einem Abfrage-Telegramm 11, 21, 31, 41, 51, 61 durch das jeweilige Smartmeter 101-109,
c) Übertragen 530 eines Antwort-Telegramms 12, 22, 32, 42, 52 des Fernabfrage-Vorgangs 10, 20, 30, 40, 50, 60 an die Überwachungsvorrichtung 4, welches den zumindest einen Kommunikationsparameter 6 umfasst,
d) Erfassen 540 der Kommunikationstopologie 120, 220, 320 des ersten Smartmeters 101 und des zumindest einen zweiten Smartmeters 102-109 aus dem zumindest einem Antwort-Telegramm 12, 22, 32, 42, 52 durch die Überwachungsvorrichtung 4,
e) Bestimmen 550 des Netzzustands des Niederspannungsnetzes 1 aus dem zumindest einen Kommunikationsparameter 6, der Netztopologie 110, 210, 310 und der Kommunikations-topologie 120, 220, 320 durch die Überwachungsvorrichtung 4.

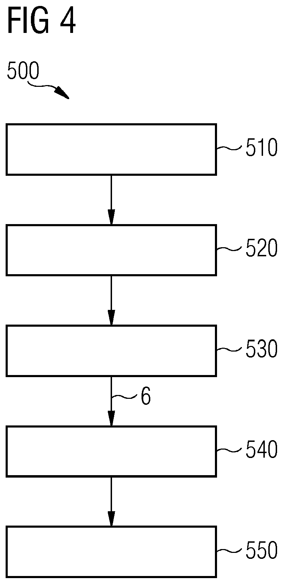

Das Verfahren 500 ist in Fig. 4 gesondert dargestellt. Die Verfahrensschritte werden in diesem Beispiel von der Überwachungsvorrichtung 4 ausgeführt, können aber auch von anderen geeigneten Systemteilen durchgeführt werden, falls keine gesonderte Überwachungsvorrichtung vorgesehen sein sollte und nur eine logische Zuordnung von Systemanteilen sinnvoll erscheint.

In Fig. 5a ist eine Zählerstands-Abfrage für die Fernabfrage-Vorgänge 10, 20, 30 gezeigt.

Im Fernabfrage-Vorgang 10 erfolgt im Abfrage-Telegramm 11 eine Zählerstands-Abfrage "MeterRead" des Smartmeters 109, welches einen Rückgabe-Parametersatz im Antwort-Telegramm liefert.

Je nach Konfiguration des Smartmeters 109 können unterschiedliche Antwort-Telegramme 12, 22, 32 gesendet werden. Die Konfiguration des Antwort-Telegramms kann auch direkt im Abfrage-Telegramm erfolgen. Dieser Aspekt ist in der Figur nicht dargestellt.

Der zumindest eine Kommunikationsparameter 6 in Form eines Parametersatzes kann aus einem Link-Quality-Index-Parameter LQI bestimmt sein, welchen das jeweilige Smartmeter 101-109 bestimmen kann. Alternativ können entsprechende Parameter im Gateway 3 bestimmt, dort gespeichert und von Überwachungsvorrichtung 4 abgerufen werden.

Dabei kann der Link-Quality-Index-Parameter LQI aus dem Signal-Rausch-Abstand zumindest aus Teilen zumindest eines Fernabfrage-Vorgangs 10, 20, 30, 40, 50, 60 bestimmt sein.

Der zumindest eine Kommunikationsparameter 6 und/oder die Kommunikationstopologie 120 kann eine Routing-Information RI umfassen.

Die Routing-Information RI beschriebt welche den Kommunikationspfad zwischen dem Gateway 3 und dem jeweiligen Smartmeter 101-109 und kann von dem jeweiligen Smartmeter 101-109 bestimmt werden.

Das Smartmeter 109 ist den Beispielen der Fig. 5a dahingehend konfiguriert, dass der Rückgabe-Parametersatz im jeweiligen Antwort-Telegramm 12, 22, 32 eine Routing-Information RI liefert, über welche Kommunikationspfade die Kommunikation mit dem Smartmeter 109 erfolgt ist. Dabei kann das jeweilige Antwort-Telegramm 12, 22, 32 von dem Gateway 3 um die Routing-Information RI angereichert werden, beziehungsweise das Gateway 3 eine gesonderte Abfrage von Smartmeter-Parametern an ein Smartmeter richten, und das jeweilige Antwort-Telegramm 12, 22, 32 aus die Routing-Information RI, welche durch das Gateway 3 bestimmt wurden, und den Smartmeter-Parametern aus der gesonderte Abfrage zusammensetzen.

Der Parametersatz enthält im Antwort-Telegramm 12 die Zählernummer 109, dem Zählerwert 500.0 kWh sowie die Routing-Information RI. In diesem ersten Beispiel erfolgte die Kommunikation über die Kommunikationspfade 125 und 129.

Der Parametersatz enthält im Antwort-Telegramm 22 die Zählernummer 109, dem Zählerwert 500.0 kWh sowie die Routing-Information RI. In diesem zweiten Beispiel erfolgte die Kommunikation über die Kommunikationspfade 224, 225 und 229.

Der Parametersatz enthält im Antwort-Telegramm 32 die Zählernummer 109, dem Zählerwert 500.0 kWh sowie die Routing-Information RI. In diesem Beispiel erfolgte die Kommunikation über die Kommunikationspfade 322, 328 und 329.

In Fig. 5b ist eine Zählerstands-Abfrage für den Fernabfrage-Vorgang 40 gezeigt.

Im Fernabfrage-Vorgang 40 erfolgt im Abfrage-Telegramm 41 eine Zählerstands-Abfrage "MeterRead" des Smartmeters 109, welches einen Rückgabe-Parametersatz im Antwort-Telegramm 42 liefert.

Das Smartmeter 109 ist im Beispiel der Fig. 5b dahingehend konfiguriert, dass der Rückgabe-Parametersatz im Antwort-Telegramm 42 einen Link-Quality-Index-Wert LQI liefert, über welche Kommunikationspfade die Kommunikation mit dem Smartmeter 109 erfolgt ist.

Der Parametersatz enthält im Antwort-Telegramm 42 die Zählernummer 109, dem Zählerwert 500.0 kWh sowie den LQI-Wert 0.47.

In Fig. 5c ist eine Betriebszustands-Abfrage für den Fernabfrage-Vorgang 50 gezeigt.

Im Fernabfrage-Vorgang 50 erfolgt im Abfrage-Telegramm 51 eine Betriebszustands-Abfrage "Ping" des Smartmeters 109, welches einen Rückgabe-Parametersatz im Antwort-Telegramm 52 liefert.

Der Parametersatz enthält im Antwort-Telegramm 52 die Zählernummer 109 sowie die Routing-Information RI. In diesem Beispiel erfolgte die Kommunikation über die Kommunikationspfade 122 und 126.

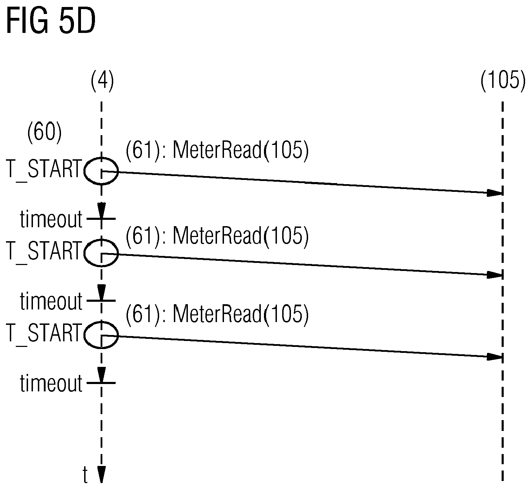

Der zumindest eine Kommunikationsparameter 6 kann auch aus der Dauer der Zeitdifferenz zwischen Absenden T_START des Abfrage-Telegramms 51 und Empfangen T_STOP des zugehörigen Antwort-Telegramms 52 des Fernabfrage-Vorgangs 50 bestimmt sein. Fig. 5d stellt ein Beispiel für einen weiteren Fernabfrage-Vorgang 60 dar.

Die Verfahrensschritte a) bis e) können auch wiederholt ausgeführt werden, beispielsweise in Form eines ersten Fernabfrage-Vorgangs und eines zweiten Fernabfrage-Vorgangs.

Beispielsweise kann aus dem ersten Fernabfrage-Vorgang und dem zweiten Fernabfrage-Vorgang eine Änderung der Kommunikationstopologie 120, 220, 320 und/oder der Netztopologie 110, 210, 310 festgestellt werden, aus welcher der Netzzustand bestimmt werden kann.

Falls auf das Abfrage-Telegramm 61 des Fernabfrage-Vorgangs 60 keine entsprechende Antwort empfangen werden kann (das heißt, es wurde ein "timeout" festgestellt), so kann das Kommunikationssystem nach einer vorbestimmten Zeitdauer nach dem Absenden T_START des Abfrage-Telegramms 61 den weiteren Empfang beenden und das unbeantwortetes Abfrage-Telegramm 61 des Fernabfrage-Vorgangs 60 entsprechend interpretieren. Optional kann das Abfrage-Telegramm 61 wiederholt übermittelt werden.

Ein fehlendes Antwort-Telegramm im Fernabfrage-Vorgang 60 kann als ein Übertragungsfehler in der jeweiligen Netzleitung interpretiert werden und der Fernabfrage-Vorgangs 60 kann als vollständig angesehen werden.

Die Netztopologie 110 beziehungsweise deren Änderungen können manuell durch einen Benutzer in der Überwachungsvorrichtung 4 erfasst werden, oder beispielsweise auch über eine entsprechende Datenschnittstelle mit anderen Vorrichtungen zur Wartung, Überwachung oder Steuerung des Niederspannungsnetzes 2.

Die Speicherung der Netztopologie 110 kann in Form einer Liste in einem Datenspeicher der Überwachungsvorrichtung 4 erfolgen.

Die Bestimmung des Versorgungszustandes des Niederspannungsnetzes kann auf unterschiedliche Art erfolgen, wie im Folgenden näher ausgeführt.

Beispielsweise lässt ein Wechsel des Kommunikationspfads 125 der Fig. 1a-1c auf den Kommunikationspfad 224, 225 der Fig. 2a-2c den Schluss zu, dass die Netzleitung 215 durch einen Verbraucher oder Witterungseinflüsse gestört ist. Wird die temporär geänderte Kommunikationstopologie 220 mit geografisch geordneten Wetterdaten in Verbindung gebracht, so kann beispielsweise gefolgert werden, dass die Leitung 215 oder deren Anschlüsse besser gegen Regen oder Sturm geschützt werden muss. Diese Folgerung kann dadurch bekräftigt werden, dass das Smartmeter 108 über die örtlich zum Unwetter nahe gelegene Leitung 218 nun über den Kommunikationspfad 228 kommuniziert.

In weiteren, nicht gezeigten Beispielen können der Kommunikationsparameter auch Kombinationen aus den Kommunikationsparametern sein. Ferner können auch andere, nicht näher ausgeführte Kommunikationsparameter für das erfindungsgemäße Verfahren verwendet werden, welche die Übertragungsqualität der Datenkommunikation eines Fernabfrage-Vorgangs zwischen einem Smartmeter und dem Gateway über Netzleitungen beschreiben.

### Bezugszeichenliste:

- 1: Niederspannungsnetz
- 2: Energieversorgungssystem
- 3: Gateway
- 4: Überwachungsvorrichtung
- 5: Smart-Grid Server
- 6: Kommunikationsparameter
- 10, 20, 30, 40, 50, 60: Fernabfrage-Vorgang
- 11, 21, 31, 41, 51, 61: Abfrage-Telegramm
- 12, 22, 32, 42, 52: Antwort-Telegramm
- 101-109: Smartmeter
- 110, 210, 310: Netztopologie
- 111-119, 211-219, 311-318: Netzleitungen
- 120, 220, 320: Kommunikationstopologie
- 121-129, 221-229, 321-329: Kommunikationspfad
- 500: Verfahren
- 510, 520, 530, 540, 550: Verfahrensschritte
- LQI: Link Quality Index
- RI: Routing-Information
- T_START: Absende-Zeitstempel eines Abfrage-Telegramms
- T_STOP: Empfang-Zeitstempel eines Antwort-Telegramms

## Patentansprüche

1. Verfahren zur Bestimmung des Netzzustandes eines Niederspannungsnetzes (1) eines Energieversorgungssystems (2),
welches Energieversorgungssystem (2) eine erste Netzleitung (111, 211, 311) mit einem ersten Smartmeter (101) und zumindest eine zweite Netzleitung (112-119, 212-219, 312-318) mit zumindest einem zweiten Smartmeter (102-109) aufweist, und die erste Netzleitung (111, 211, 311) und die zumindest eine zweite Netzleitung (112-119, 212-219, 312-318) eine Netztopologie (110, 210, 310) des Niederspannungsnetzes (1) bilden,
und das erste Smartmeter (101) sowie das zumindest eine zweite Smartmeter (102-109) über jeweils einen Kommunikationspfad mit zumindest einem Gateway (3) eines Kommunikationssystems des Energieversorgungssystems (2) verbunden sind und mittels zumindest eines Fernabfrage-Vorgangs (10, 20, 30, 40, 50, 60), umfassend jeweils ein Abfrage-Telegramm (11, 21, 31, 41, 51, 61) und ein Antwort-Telegramm (12, 22, 32, 42, 52), kommunizieren, wobei die Kommunikationspfade ein Kommunikationsnetz mit einer Kommunikationstopologie (120, 220, 320) bilden,
**dadurch gekennzeichnet, dass** folgende Verfahrensschritte (500) ausgeführt werden:
a) Senden (510) des Abfrage-Telegramms (11, 21, 31, 41, 51, 61) des Fernabfrage-Vorgangs (10, 20, 30, 40, 50, 60) an das erste Smartmeter (101) und das zumindest eine zweite Smartmeter (102-109),
b) Ermitteln (520) von Eigenschaften der Kommunikation zwischen dem zumindest einen Gateway (3) und dem ersten Smartmeter (101) und/oder dem zumindest einen zweiten Smartmeter (102-109) als zumindest ein Kommunikationsparameter (6) aus dem zumindest einen Abfrage-Telegramm (11, 21, 31, 41, 51, 61) durch das jeweilige Smartmeter (101-109),
c) Übertragen (530) eines Antwort-Telegramms (12, 22, 32, 42, 52) des Fernabfrage-Vorgangs (10, 20, 30, 40, 50, 60) an eine Überwachungsvorrichtung (4) des Energieversorgungssystems (2), welches den zumindest einen Kommunikationsparameter (6) umfasst,
d) Erfassen (540) der Kommunikationstopologie (120, 220, 320) des ersten Smartmeters (101) und des zumindest einen zweiten Smartmeters (102-109) aus dem zumindest einem Antwort-Telegramm (12, 22, 32, 42, 52) durch die Überwachungsvorrichtung (4),
e) Bestimmen (550) des Netzzustands des Niederspannungsnetzes (1) aus dem zumindest einen Kommunikationsparameter (6), der Netztopologie (110, 210, 310) und der Kommunikationstopologie (120, 220, 320) durch die Überwachungsvorrichtung (4).

2. Verfahren nach dem vorhergehenden Anspruch, wobei der zumindest eine Kommunikationsparameter (6) aus einem Link Quality Index (LQI) Parameter des jeweiligen
Smartmeters (101-109) bestimmt wird.

3. Verfahren nach dem vorhergehenden Anspruch, wobei der Link Quality Index (LQI) Parameter aus dem Signal-Rausch-Abstand zumindest aus Teilen zumindest eines Fernabfrage-Vorgangs (10, 20, 30, 40, 50, 60) bestimmt wird.

4. Verfahren nach einem der vorhergehenden Ansprüche, wobei der zumindest eine Kommunikationsparameter (6) und/oder die Kommunikationstopologie (120, 220, 320) aus einer Routing-Information (RI), welche den Kommunikationspfad zwischen dem zumindest einen Gateway (3) und dem jeweiligen Smartmeter (101-109) beschreibt und vorzugsweise die Routing-Information (RI) von dem jeweiligen Smartmeter (101-109) bestimmt wird.

5. Verfahren nach einem der vorhergehenden Ansprüche, wobei der zumindest eine Kommunikationsparameter (6) aus der Dauer der Zeitdifferenz zwischen Absenden (T_START) des zumindest einen Abfrage-Telegramms (11, 21, 31, 41, 51, 61) und Empfangen (T_STOP) des zugehörigen Antwort-Telegramms (12, 22, 32, 42, 52) des eines jeweiligen Fernabfrage-Vorgangs (10, 20, 30, 40, 50, 60) bestimmt wird.

6. Verfahren nach einem der vorhergehenden Ansprüche, wobei die Schritte a) bis e) als ein erster Fernabfrage-Vorgang (30) und zumindest ein zweiter Fernabfrage-Vorgang (31) wiederholt ausgeführt werden, wobei aus dem ersten Fernabfrage-Vorgang (30) und dem zumindest einen zweiten Fernabfrage-Vorgang (31) eine Änderung der Kommunikationstopologie (120, 220, 320) und/oder der Netztopologie (110, 210, 310) feststellbar ist, aus welcher der Netzzustand bestimmbar ist.

7. Verfahren nach einem der vorhergehenden Ansprüche, wobei die Netztopologie (110, 210, 310) von der Überwachungsvorrichtung (4) erfasst ist und vorzugsweise in Form einer Liste in einem Datenspeicher der Überwachungsvorrichtung (4) gespeichert und änderbar ist.

8. Verfahren nach einem der vorhergehenden Ansprüche, wobei das Abfrage-Telegramm (11, 21, 31, 41, 51, 61) eine Zählerstands-Abfrage oder eine Betriebszustands-Abfrage des jeweiligen Smartmeters (101-109) umfasst.

9. Vorrichtung zur Bestimmung des Netzzustandes eines Niederspannungsnetzes (1) eines Energieversorgungssystems (2),
welches Energieversorgungssystem (2) eine erste Netzleitung (111, 211, 311) mit einem ersten Smartmeter (101) und zumindest eine zweite Netzleitung (112-119, 212-219, 312-318) mit zumindest einem zweiten Smartmeter (102-109) aufweist, und die erste Netzleitung (111, 211, 311) und die zumindest eine zweite Netzleitung (112-119, 212-219, 312-318) eine Netztopologie (110, 210, 310) des Niederspannungsnetzes (1) bilden,
und das Energieversorgungssystem (2) ferner ein Kommunikationssystem mit zumindest einem Gateway (3) aufweist, welches dazu eingerichtet ist, das erste Smartmeter (101) sowie das zumindest eine zweite Smartmeter (102-109) über jeweils einen Kommunikationspfad mit dem zumindest einen Gateway (3) zu verbinden und mittels zumindest eines Fernabfrage-Vorgangs (10, 20, 30, 40, 50, 60), umfassend jeweils ein Abfrage-Telegramm (11, 21, 31, 41, 51, 61) und ein Antwort-Telegramm (12, 22, 32, 42, 52), zu kommunizieren, wobei die Kommunikationspfade ein Kommunikationsnetz mit einer Kommunikationstopologie (120, 220, 320) bilden,
**dadurch gekennzeichnet, dass**
das Energieversorgungssystem (2) ferner eine Überwachungsvorrichtung (4) umfasst, welche mit dem zumindest einen Gateway (3) verbunden ist, und das Energieversorgungssystem (2) dazu eingerichtet ist, folgende Verfahrensschritte auszuführen:
a) Senden (510) des Abfrage-Telegramms (11, 21, 31, 41, 51, 61) des Fernabfrage-Vorgangs (10, 20, 30, 40, 50, 60) an das erste Smartmeter (101) und das zumindest eine zweite Smartmeter (102-109),
b) Ermitteln (520) von Eigenschaften der Kommunikation zwischen dem zumindest einen Gateway (3) und dem ersten Smartmeter (101) und/oder dem zumindest einen zweiten Smartmeter (102-109) als zumindest ein Kommunikationsparameter (6) aus zumindest einem Abfrage-Telegramm (11, 21, 31, 41, 51, 61) durch das jeweilige Smartmeter (101-109),
c) Übertragen (530) eines Antwort-Telegramms (12, 22, 32, 42, 52) des Fernabfrage-Vorgangs (10, 20, 30, 40, 50, 60) an die Überwachungsvorrichtung (4), welches den zumindest einen Kommunikationsparameter (6) umfasst,
d) Erfassen (540) der Kommunikationstopologie (120, 220, 320) des ersten Smartmeters (101) und des zumindest einen zweiten Smartmeters (102-109) aus dem zumindest einem Antwort-Telegramm (12, 22, 32, 42, 52) durch die Überwachungsvorrichtung (4),
e) Bestimmen (550) des Netzzustands des Niederspannungsnetzes (1) aus dem zumindest einen Kommunikationsparameter (6), der Netztopologie (110, 210, 310) und der Kommunikationstopologie (120, 220, 320) durch die Überwachungsvorrichtung (4).

10. Vorrichtung nach dem vorhergehenden Anspruch, wobei der zumindest eine Kommunikationsparameter (6) aus einem Link Quality Index (LQI) Parameter des jeweiligen
Smartmeters (101-109) bestimmt wird, und vorzugsweise der Link Quality Index (LQI) Parameter aus dem Signal-Rausch-Abstand zumindest aus Teilen zumindest eines Fernabfrage-Vorgangs (10, 20, 30, 40, 50, 60) bestimmt wird.

11. Vorrichtung nach einem der Ansprüche 9 oder 10, wobei der zumindest eine Kommunikationsparameter (6) und/oder die Kommunikationstopologie (120, 220, 320) aus einer Routing-Information (RI), welche den Kommunikationspfad zwischen dem zumindest einen Gateway (3) und dem jeweiligen
Smartmeter (101-109) beschreibt und vorzugsweise die Routing-Information (RI) von dem jeweiligen Smartmeter (101-109) bestimmt wird.

12. Vorrichtung nach einem der Ansprüche 9 bis 11, wobei der zumindest eine Kommunikationsparameter (6) aus der Dauer der Zeitdifferenz zwischen Absenden (T_START) des zumindest einen Abfrage-Telegramms (11, 21, 31, 41, 51, 61) und Empfangen (T_STOP) des zugehörigen Antwort-Telegramms (12, 22, 32, 42, 52) des eines jeweiligen Fernabfrage-Vorgangs (10, 20, 30, 40, 50, 60) bestimmt wird.

13. Vorrichtung nach einem der Ansprüche 9 bis 12, wobei die Schritte a) bis e) als ein erster Fernabfrage-Vorgang (30) und zumindest ein zweiter Fernabfrage-Vorgang (31) wiederholt ausgeführt werden, wobei aus dem ersten Fernabfrage-Vorgang (30) und dem zumindest einen zweiten Fernabfrage-Vorgang (31) eine Änderung der Kommunikationstopologie (120, 220, 320) und/oder der Netztopologie (110, 210, 310) feststellbar ist, aus welcher der Netzzustand bestimmbar ist.

14. Vorrichtung nach einem der Ansprüche 9 bis 13, wobei die Netztopologie (110, 210, 310) von der Überwachungsvorrichtung (4) erfasst ist und vorzugsweise in Form einer Liste in einem Datenspeicher der Überwachungsvorrichtung (4) gespeichert und änderbar ist.

15. Vorrichtung nach einem der Ansprüche 9 bis 14, wobei das Abfrage-Telegramm (11, 21, 31, 41, 51, 61) eine Zählerstands-Abfrage oder eine Betriebszustands-Abfrage des jeweiligen Smartmeters (101-109) umfasst.
